# EUROPEAN PATENT APPLICATION

(11) **EP 1 223 612 A1**
(43) Date of publication of application: **17.07.2002**
(21) Application number: 01930048.2
(22) Date of filing: 11.05.2001
(51) Int. Cl.: H01L 21/60, H01L 23/29

(54) **SEMICONDUCTOR DEVICE MOUNTING CIRCUIT BOARD, METHOD OF PRODUCING THE SAME, AND METHOD OF PRODUCING MOUNTING STRUCTURE USING THE SAME**

(30) Priority: 12.05.2000 JP 2000140072
(71) Applicant: MATSUSHITA ELECTRIC INDUSTRIAL CO., LTD., Kadoma-shi, Osaka 571-8501 (JP)
(72) Inventor: ONO, Masahiro, Sakai-shi, Osaka 593-8308 (JP); SHIRAISHI, Tsukasa, Takatsuki-shi, Osaka 569-0043 (JP)
(74) Representative: Eisenführ, Speiser & Partner
(86) International application number: PCT/JP01/03922
(87) International publication number: WO 01/86716

(57) **Abstract**

The invention is intended for providing a semiconductor package structure which prevents degradation in characteristics of a semiconductor device and breakage of the interconnections when the semiconductor device is packaged on a circuit substrate. In the package structure having the semiconductor device mounted on the circuit substrate, bump electrodes of the semiconductor device are placed on input/output terminal electrodes of the circuit substrate and are electrically and mechanically connected thereto by bonding with conductive adhesive, and the semiconductor device is bonded and fixed to the circuit substrate by a resin film formed previously on a surface of the substrate. The structure does no damage to a semiconductor functional part and to interconnections, and allows mounting with a lower load in comparison with structures using conventional anisotropic conductive films and the like, so that heat-press bonding mounting with a high productivity and a low cost can be applied.

## Description

### TECHNICAL FIELD

The present invention relates to a circuit substrate to be mounted with a semiconductor device and a method of producing the same. The invention also relates to a method of mounting a semiconductor device with use of such a circuit substrate.

### BACKGROUND ART

As one of techniques for mounting semiconductor devices on a circuit substrate, flip chip mounting methods have been known. In one of the methods, bump electrodes are formed on a surface of a semiconductor chip on the same side as the function element thereof is formed, and are connected through an adhesive layer to input/output terminal electrodes arranged on a circuit substrate. In this method, the bump electrodes are formed of gold (Au), nickel (Ni) or the like by plating, and for the adhesive layer solder, conductive organic adhesive or the like is used. As conductive organic adhesive, anisotropic conductive film or paste, or the like are used besides isotropic adhesive.

Although Solder paste and isotropic conductive adhesive require little load for the connection in packaging, anisotropic conductive film and anisotropic conductive paste require to be loaded on the level of 200 g per pin at the maximum in packaging processes in order to secure stability of conductivity and reliability.

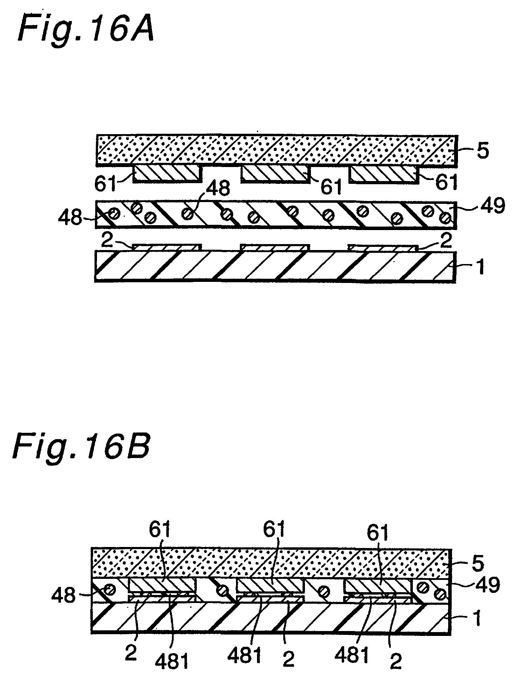

Fig. 16 shows an example of conventional flip chip mounting technique using anisotropic conductive resin film (see Isao Tsukagoshi et al; "Electronics Jisso Gijutsu," 1997 March, p. 46-49, Gijutsu Chosakai Co., Ltd.). In this method, terminal electrodes of a semiconductor substrate are bonded to terminal electrodes of a circuit substrate by means of an anisotropic conductive resin film. The anisotropic conductive resin film contains epoxy resin conductive particles such as Ni metal particles or Au-coated resin particles as main ingredients of adhesive. In assembly, the circuit substrate and the semiconductor device are heated under a load and the conductive resin film is interposed and pressed between the electrodes, so that the conductive particles in the resin film are brought into contact with one another to achieve all the electric connections between the electrodes facing each other.

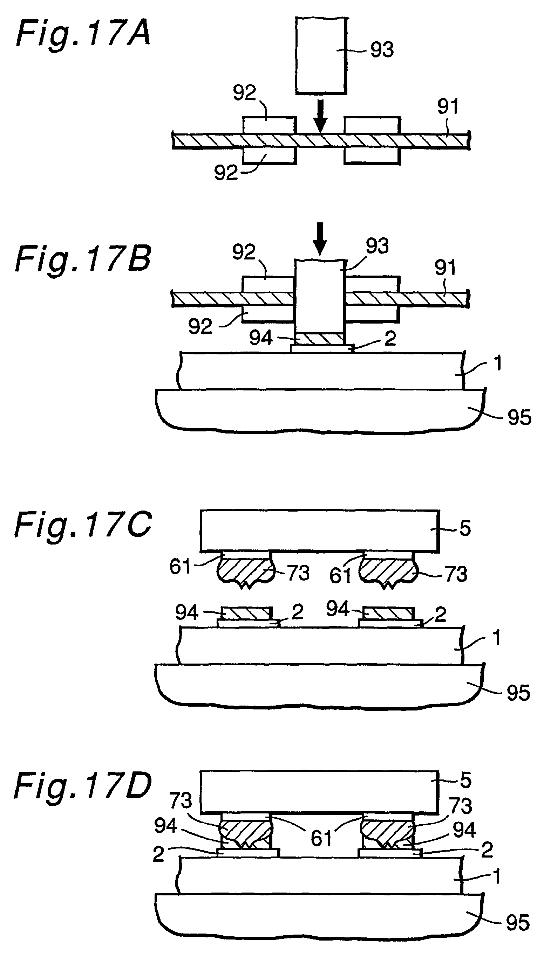

Japanese Patent Publication 8-037206 discloses a method of semiconductor device packaging in which, as shown in Figs. 17A to 17D, a conductive adhesive sheet 91 being in B-stage is interposed between dies 92, 92 and punched out by a punch 93 (Fig. 17A) into small pieces 94 of the conductive sheet each which are aligned with and bonded to a corresponding pad electrode 2 on a circuit substrate 1 so as to be used as an adhesive layer (Fig. 17B). On the other hand, ball bumps 73 are formed on electrode pads 61 of a semiconductor chip 5 (Fig. 17C). In mounting, the ball bumps 73 on the semiconductor chip 5 are heated and bonded to the corresponding small pieces 94 of the conductive sheet on the circuit substrate 1 so that each of the ball bumps is connected to the corresponding electrode (Fig. 17D).

Japanese Patent Publication 10-199932 discloses a method for packaging a semiconductor device in which electrically conductive and plastically deformable bumps are formed on a large number of pad electrodes on a semiconductor chip, are leveled in a height, and such bump on the semiconductor device are pressed to and bonded to, the corresponding pads on a circuit substrate. When bonding, adhesive is applied to flat head planes of the leveled bumps which are joined to the corresponding pads.

In recent years, semiconductor devices have increasingly been required to have high compactness and performance for use in portable electronic equipment. In order to fulfill the requirements, it is important that semiconductor devices to be mounted on and interconnected to circuit substrates should be provided with an increased number of pins for input/output terminals with a much smaller pitch between the adjacent terminals and that an area array of electrodes can be achieved in a zone where the electrodes can be arranged. This requires further development of techniques for achieving narrower-pitch connection.

The area array arrangement of electrodes has been established by conventional solder bump methods. The solder bump technique has the advantages that stresses acting on the active elements on an integrated circuit chip in mounting are relatively small, allowing the integrated circuit chip to sustain no damage. However, the diameter of solder bumps is so large that the electrode arrangement for mounting with area array arrangement has been limited to the electrode pitch of about 250 µm if necessity of miniaturizing the processes of substrates and package reliability are considered.

The above heat-press bonding technique using anisotropic conductive adhesive has been noted from the viewpoint of production efficiency improvement for cost reduction, because productivity in the packaging process is higher than ever has been expected.

In the above heat-press bonding method using anisotropic conductive resin film, by pressing the conductive resin film between each of the bump electrodes on the semiconductor chip and the corresponding bump electrode on the substrate, the conductive particles are brought into contact with one another to impart electrical conductivity between the bump electrode on the semiconductor chip and the corresponding bump electrode of the substrate. For providing the connection between the electrodes, a considerably large load between the electrodes in mounting is required to be, for example, not less than 200 g per bump electrode. This force may damage a semiconductor circuit or may cause failures, or breakage, of Al interconnections on the semiconductor substrate.

In packaging by using this method, the whole conductive resin is cured while the semiconductor substrate is being pressed with a large force so as to be brought into direct contact with the input/output terminal electrodes of the circuit substrate, so that stress taking place between the electrodes facing each other produces residual stress within the semiconductor substrate, therefore, reducing the performance of the semiconductor circuit. In particular, pressure exerting the bump electrodes at the time of mounting may cause the input/output terminal electrodes of the circuit substrate to be deformed into fracture in via hole filling in the substrate connected to the electrodes, resulting in faulty connections in the circuit substrate.

This may happen because in the case of anisotropic conductive resin, conductive particles contained in the anisotropic conductive film and silica filled therein for controlling thermal expansion coefficient can stress a surface on the side of the semiconductor functional part of the semiconductor chip due to pressure during packaging.

In the packaging technique disclosed in Japanese Patent Publication No. 8-037206, there has been a problem that the bonding of a large number of ball bumps to the adhesive layers reduces reliability because the small pieces of the conductive sheet punched from a conductive adhesive sheet must be handled. While loads in packaging are partially applied only to the vicinity of the electrodes, therefore, reducing damage to the semiconductor device, an increase in the pressure for ensuring the bonding may cause a risk to destruct via holes beneath the pad electrodes because the bump electrodes apply pressure to the pad electrodes on the circuit substrate and stress the pad electrodes. Another problem is that the conductive adhesive sheet is very weak in adhesive strength for joining the semiconductor device to the circuit substrate, resulting in reducing reliability of the semiconductor package.

In the above method of Japanese Patent Publication No. 10-199932, adhesive is applied to tops of the bumps on the semiconductor chip and then the bumps are joined to surfaces of the pads, resulting in unevenness in height of the bumps which causes faulty bonding; therefore, in order to improve reliability of all the adhesions between the opposing electrodes, the bumps are required to be previously leveled in height. Though the pressing bumps might be deformed so as to collapse and bonding could be thereby reinforced, there is a danger that such a deformation might result in damage to the semiconductor chip as described above.

### DISCLOSURE OF THE INVENTION

It is an object of the present invention to provide a circuit substrate which is to constitute a package structure of mounting a semiconductor device thereon which allows connections between electrodes without exerting stress to electrodes or degrading in characteristics of the semiconductor device when packaging.

It is another object of the invention to provide a method for allowing connections between electrodes without development of residual stress between electrodes when mounting a semiconductor device on the circuit substrate, and a method of producing such a package structure.

The circuit substrate of the invention includes conductive resin adhesive layers which are bonded onto input/output electrodes on a surface of the circuit substrate for connection between electrodes, and a resin film that has previously covered the surface of the substrate including the conductive resin adhesive layers. Bump electrodes corresponding to those, having pointed heads, are formed on electrodes of a semiconductor chip.

When the semiconductor device is mounted on the circuit substrate, the bump electrodes of the semiconductor device are pressed toward the electrodes on the circuit substrate such that the sharp pointed heads of the bump electrodes pierce the resin film on the circuit substrate and reach the respective conductive adhesive layers. The conductive adhesive layers receive the bump electrodes, connect thereto fixedly, and relax stresses to be developed to the semiconductor device by the bump electrodes, which avoids damaging semiconductor circuits and interconnections on the semiconductor device. Even if the heads of some bump electrodes do not reach the pad electrodes because of warp in the circuit substrate or unevenness in height of the pointed heads, the pointed heads are received within the conductive adhesive layers so that electric connection between the electrodes can be secured by conductivity of the conductive adhesive layers.

In the present invention, the resin film serves also as a protective coating which protects the pad electrodes for the circuit substrate. For the package structure, the resin film has a function of supporting and reinforcing connection regions including the bump electrodes and the conductive adhesive layers to integrally join the surface of the substrate to a surface of the semiconductor circuit, thus ensuring electric and mechanical reliability of the package structure and enabling heat-press packaging suitable for a high productivity .

The package structure of the present invention is capable of preventing degradation in characteristics of a semiconductor functional part and failures such as breaks in interconnection that have been problems with conventional anisotropic conductive films because the conductive adhesive relaxes stress during packaging. Besides, use of conductive adhesive allows mounting with a low load, because such a mounting load as deforms the pad electrodes of the circuit substrate is not required. Moreover, addition of conductive adhesive having a flexible nature into a junction layer leads to provision of the package structure that is more reliable than conventional structures. The package structure can be applied as heat-press bonding mounting with a high productivity and a low cost that causes no damage, in contrast to typical package structures for integrated circuit.

### BRIEF DESCRIPTION OF THE DRAWINGS

Fig. 1A shows a schematic cross-sectional view of a circuit substrate according to an embodiment of the invention;
Fig. 1B shows a schematic cross-sectional view of a multilayered circuit substrate according to the embodiment of the invention;
Fig. 2A shows an arrangement of the circuit substrate and a semiconductor device in a producing process according to a embodiment of the invention;
Fig. 2B shows a package structure for the semiconductor device in a state where the circuit substrate and the semiconductor device shown in Fig. 2A have been assembled;
Figs. 3A to 3D show processes of producing the circuit substrate according to an embodiment of the invention, in schematic cross sectional view;
Figs. 4A to 4D show processes of another method of producing the circuit substrate according to another embodiment of the invention, in schematic sections;
Figs. 5A to 5H show processes of a method of producing the circuit substrate according to still another embodiment of the invention, in schematic sections;
Fig. 6A shows a schematic cross-sectional view of a package structure according to an embodiment of the invention;
Fig. 6B shows a schematic section of a resin film for a circuit substrate used in the package structure of Fig. 6A;
Fig. 6C shows a schematic cross-sectional view illustrating a process of assembling the package structure with use of the resin film shown in Fig. 6B;
Fig. 7A shows an arrangement of the resin film for a circuit substrate, the circuit substrate, and a semiconductor device in a producing process according to the embodiment of the invention;
Fig. 7B shows the package structure assembled with use of the circuit substrate and the resin film of Fig. 7A, in a schematic section;
Fig. 8A shows an arrangement of a circuit substrate and a semiconductor device in a producing process in accordance with an embodiment of the invention;
Fig. 8B shows a package structure assembled with use of the circuit substrate of Fig. 8A, in schematic cross-sectional view;
Fig. 9A shows an arrangement of a circuit substrate and a semiconductor device in a producing process in accordance with the embodiment of the invention, and Fig. 9B shows a package structure that has been assembled with use of the circuit substrate of Fig. 9A, in schematic section;
Fig. 10 is a schematic cross-sectional view of a package structure in accordance with the embodiment of the invention;
Fig. 11 is a schematic cross-sectional view of a package structure used in an embodiment of the invention;
Fig. 12A is a graph showing the relation between mounting load and connection resistance in the embodiment of the invention;
Fig. 12B is a graph showing changes in connection resistance with respect to temperature in the embodiment;
Fig. 12C is a graph showing relations between heating-cooling cycle and stability of connection resistance in the embodiment of the invention;
Figs. 13A to 13E are metallographical photographs each showing a metal section of a connection part between a bump electrode and a conductive adhesive layer in the embodiment in which a glass epoxy substrate was used as a circuit substrate and in which connection was made with amounting load varied as parameter;
Fig. 13F shows a photomicrograph of a metal section of a connection part between a bump electrode and a conductive adhesive layer in the embodiment in which a glass ceramic substrate was used;
Fig. 14A shows relations between all-series resistance of all connection portions in an embodiment of the invention and repeated heat cycles in a solder heat test;
Fig. 14B shows temperature dependency of all-series resistance in a test on the connection part in the embodiment of the invention;
Fig. 14C shows relations between number of heating-cooling cycles in a temperature cycling test and connection. resistance in the connection part in the embodiment of the invention;
Fig. 15 is a metallographical photograph of a metal section of a junction of a package structure in which mounting has been executed with use of conductive adhesive and a resin film of the invention;
Fig. 16A shows an arrangement of a circuit substrate and a semiconductor device in mounting with use of a conventional anisotropic conductive film;
Fig. 16B shows a package structure that has been assembled as shown in Fig. 16A, in a schematic section; and
Figs. 17A to 17D are schematic sections showing a method of mounting a semiconductor device in accordance with a prior art.

### BEST MODE FOR CARRYING OUT THE INVENTION

The circuit substrate of the present invention is a circuit substrate to be mounted with a semiconductor device, comprising input/output terminal electrodes formed on a surface thereof, conductive adhesive layers attached to the terminal electrodes, and a resin film formed on the surface of the substrate so as to cover the terminal electrodes and the conductive adhesive layers.

Such a circuit substrate may be produced as follows. Conductive adhesive may be applied by printing onto the input/output terminal electrodes formed on the surface of the substrate and the conductive adhesive layers can be thereby formed. After the conductive adhesive layers are cured, the surface of the substrate is coated with the resin film so that the film covers the conductive adhesive layers together with the terminal electrodes.

The circuit substrate of the invention is used in order that a semiconductor device may be mounted on the circuit substrate for producing the package structure of the semiconductor device. In the package structure, bump electrodes on the semiconductor device are electrically connected through conductive adhesive to the input/output terminal electrodes on the circuit substrate, and the semiconductor device is bonded and fixed to the circuit substrate by the resin film which has previously been formed on the circuit substrate.

At the time such a package structure is assembled, the bump electrodes having pointed heads have previously been formed on input/output electrodes of the semiconductor device and, on the other hand, the circuit substrate is provided with the input/output terminal electrodes on the surface of the circuit substrate, the conductive adhesive layers applied onto the terminal electrodes, and a resin film covering the surface of the substrate and the conductive adhesive layers. The package structure is assembled and produced as follows. The semiconductor device are pressed to the circuit substrate so as to insert the bump electrodes into the resin film melted on the circuit substrate that has been heated and to be fixed to the respective conductive adhesive layers, and then the bump electrodes are electrically connected to the corresponding terminal electrodes of the circuit substrate before the resin film is cured to join the semiconductor device to the circuit substrate.

In the present invention, at the time of packaging, the conductive adhesive layers, which comprise composite material containing conductive particles dispersed in high density in resin component, have already been heated, remaining softened. When fitter onto the terminal electrodes on the circuit substrate, the bump electrodes having the pointed heads on the semiconductor device have only to reach the softened conductive adhesive layers, but do not require so high a pressure as deforms the electrodes of the circuit substrate, i.e., the semiconductor device can be joined to the circuit substrate even with a low mounting load. The conductive adhesive on the circuit substrate receives the bump electrodes, deforms itself to lessen stress which is to be developed by the reception, and therefore prevents residual stress from remaining in the semiconductor device. As a result, degradation in characteristics of the semiconductor device, breaks in interconnection, and the like can be prevented effectively.

Moreover, the circuit substrate may originally be provided with the conductive adhesive layers on the electrodes on the surface of the circuit substrate and with the resin film (film) which fully covers the surface of the substrate together with the conductive adhesive layers so that semiconductor devices can be packaged by one procedure of heat-press bonding, thus achieving a packaging operation at a low cost.

The conductive adhesive may be prepared by kneading a pasty mixture of a resin component and conductive particles as conductive filler. When used, the adhesive is coated, in thin lyaer, to a top surface of each of the input/output terminal electrodes (i. e., pad electrodes) on the circuit substrate to form the conductive adhesive layer.

The resin component of the conductive adhesive may be selected from thermoplastic resins and thermosetting resins, and epoxy resin may be preferably used in viewpoints of stability, and electric insulation, especially, high-frequency performance, and strength, especially, high heat resistance. The resin component is solid at ordinary temperatures, and preferably, may be suitably softened or melted when being moderately heating in mounting operation.

As the conductive particles, there can be used particles formed of a metal selected from noble metals of Cu, Ag, and Au, the iron group of Fe, Ni and Co, the platinum group of Pt, Pd, et al, and other metals such as Zn, and carbon C. Resin particles coated with metal on surfaces thereof, such as Au-coated resin particles, also can be used.

On the other hand, the resin film is made of a resin selected among thermosetting resins which, in the mounting operation, can be softened or melted under moderate heat applied to the whole substrate. As such a resin, for example, thermosetting epoxy resin, silicone resin, urethane resin, polyvinyl chloride resin, phenolic resin, acrylic resin, polyester, polycarbonate, and polyacetal can be used, and particularly, epoxy resin may be preferable.

The resin film may further contain powdery filler that is suitable for viscosity control, expander or reinforcement. As the filler, for example, there can be used inorganic particles such as silica SiO₂, alumina Al₂O₃, silicon nitride Si₃N₄, silicon carbide SiC, and aluminum nitride AlN. In this case, the resin film exhibits insulation.

It is preferable for such conductive adhesive layers to have a thickness not greater than 10 µm on the electrodes, and it is particularly preferable for the layers to have a thickness on the order of 0.1 to 3 µm.

The resin film may contain conductive particles as the filler, the conductive particles being used, for example, as anisotropic conductive resin film containing suitable metal particles. In this case, the resin film has only to be insulating under no load or pressure in the mounting even when the resin film is sandwiched between the electrodes. Electric connections between the electrodes can be provided by the conductive adhesive layers that are separately provided on the electrodes.

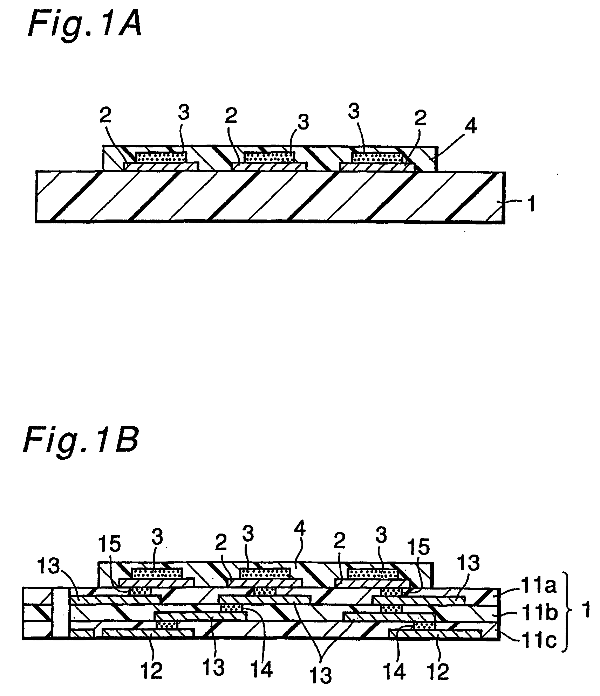

Figs. 1A and 1B show a schematically cross-sectional view of a circuit substrate 1. Input/output terminal electrodes 2 are formed on a surface of the circuit substrate 1, and, in this example, the terminal electrodes 2 have flat top surfaces on which conductive adhesive layers 3 are formed. A resin film 4 is attached and adheres to the whole surface of the circuit substrate 1, in this example, so as to cover the conductive adhesive layers 3 and the input/output terminal electrodes 2. Fig. 1A shows an example of a single-layer resin substrate and Fig. 1B shows an example of application to a multilayered resin substrate. In the substrate 1 of this example in Fig. 1B, there are arranged three resin insulating layers 11a, 11b, and 11c and interlayer electrodes 13 having specified patterns and interposed between the layers, and the upper and lower interlayer electrodes are connected by conductors, i.e., via conductors 14, formed through the insulating layers 11a, 11b, and 11c. The via conductors 15 on the top surface are connected to the pad electrodes 2 on the surface, and electrodes 12 for interconnection are provided on a lower surface of the resin insulating layer 11c, i.e., the lowermost layer.

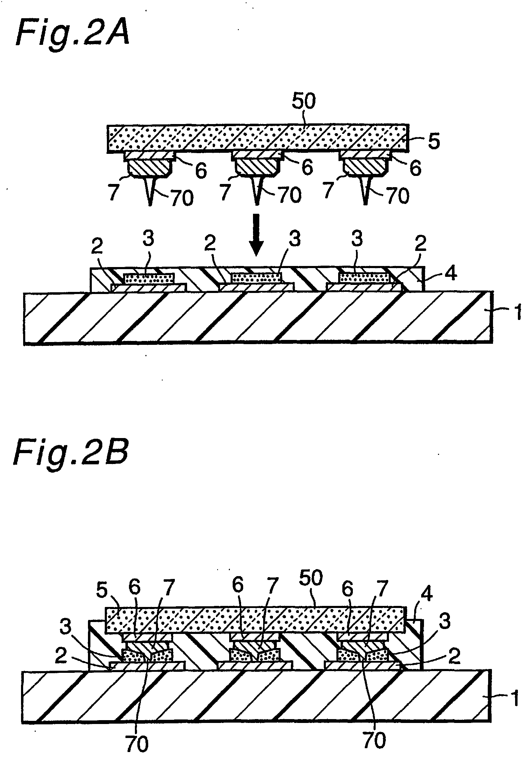

Fig. 2A shows a process of packaging a semiconductor device 5 on the circuit substrate 1 and Fig. 2B shows a package structure in which the semiconductor device 5 has been joined to the circuit substrate 1.

In the semiconductor device 5 of this example in Fig. 2A, a semiconductor functional part ((not shown) e.g., an integrated circuit portion) and a large number of input/output terminal electrodes 6 (pad electrodes) connected to the semiconductor functional part are formed on a surface of a semiconductor substrate 50 and projection electrodes 7 (bump electrodes) having pointed heads are formed on the terminal electrodes.

As described above, the circuit substrate 1 to receive the semiconductor device 5 is originally formed with conductive resin adhesive layers 3 positioned on the input/output terminal electrodes 2 on the surface of the circuit substrate 1, corresponding to the bump electrodes 7 of the semiconductor device 5, and with a resin film 4 which covers the whole circuit substrate 1.

In the mounting operation, the semiconductor device is sucked by a head heated of a mounting machine provided with a heater, and is heated and pressed to the circuit substrate so that the bump electrodes 7 inserted into the corresponding conductive adhesive layers 3 on the substrate, and later, the semiconductor device is cooled. The bump electrodes 7 are thereby bonded to the conductive adhesive layers 3, and the semiconductor substrate 50 of the semiconductor device is bonded and fixed onto the circuit substrate 1 by the resin film 4. In this process, the circuit substrate also may be preferably heated such that the conductive adhesive 3 and the resin film are softened.

Fig. 2B shows the package structure in which the semiconductor device 5 has been mounted on the circuit substrate 1. In this structure, the conductive adhesive layers 3 on the circuit substrate receives the bump electrodes 7 of the semiconductor device 5, and bonds and fixes the bump electrodes 7 by bonding effect of the adhesive layers. Further, the resin film 4 having covered the surface of the substrate now fills a gap between the circuit substrate 1 and the semiconductor device 5, which bonds the circuit substrate 1 to the semiconductor device 5 and to fix both stably.

This circuit substrate 1 as described above, configured by formation of the adhesive layers on the surface of the substrate and by coating of the resin film 4 thereon, may be formed as follows. Input/output terminal electrodes 2 (pad electrodes) have previously been formed on the surface of the circuit substrate so as to correspond accurately to the input/output terminal electrodes 6 of the semiconductor device 5 and, in a process of forming the conductive adhesive layers 3, conductive adhesive is preferably applied by printing process onto the input/output terminal electrodes 2 formed on the surface of the substrate. Alternatively, conductive adhesive transferred onto the bump electrodes of the device may be transferred again onto the input/output terminal electrodes of the circuit substrate.

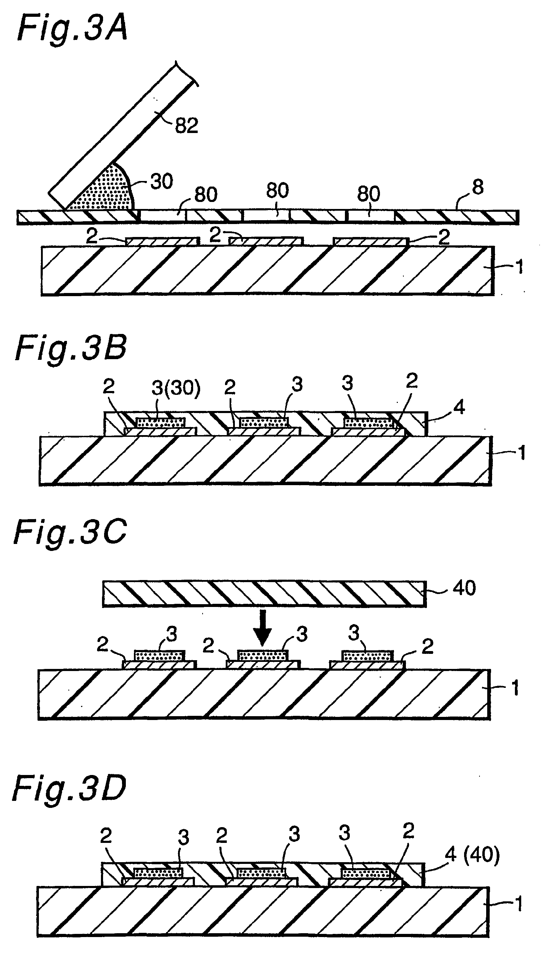

For the printing process of forming the adhesive layers, Figs. 3A and 3B show an example using screen printing. The printing process includes preparation of paste 30 of conductive adhesive from a liquid resin component and conductor particles (e.g., silver particles) and required viscosity modifier or the like. As shown in Fig. 3A, a screen mask 8 is positioned with respect to the terminal electrodes 2 on the circuit substrate 1 so as to mask other portion of the substrate than the terminal electrodes 2, and the paste 30 is developed on the screen mask 8 by a squeegee 82 to be applied only onto the terminal electrodes 2 in a required thickness. The conductive adhesive layers 3 are thereby applied on the terminal electrodes 2 as shown in Fig. 3B, and are subsequently cured. If a solvent-type adhesive is used as conductive adhesive, the adhesive can be cured by volatilizing the solvent therein.

In a subsequent resin film coating process, a thermosetting resin film 40 may be used which has previously been formed for the resin film and which has an appropriate adhesive property, in which case, as shown in Fig. 3C, the resin film 40 is heated to be softened and is bonded onto the surface of the substrate so as to cover both the conductive adhesive and the terminal electrodes 2 thereon. The resin film is heated to such that a surface of the resin film 40 sticks for bonding. As a result of this process, as shown in Fig. 3D, the circuit substrate 1 can be obtained on which the conductive adhesive and the resin film 4 are stacked.

For the bump electrode 7 of the semiconductor device a structure can be used which has a projecting portion 70 at an extremity thereof and is capable of piercing the resin film 4 and the conductive adhesive layer 3. For example, there can be used projected conductive electrodes 7 made with use of wire bonding method, or projected electrodes 7 formed with use of electroplating or electroless plating method. In particular, projection electrodes shaped by plucking away molten metal using the wire bonding method may be used as the bump electrodes 7, and, in mounting operation, the pointed head of each of the bump electrodes can produce an increased force to pierce into the resin film 4 at the time of mounting, providing stable connections between the electrodes by pressing with a lower load to the substrate. For such bump electrodes, for example, low-melting metal or alloy thereof, containing Au, Sn, Ag, Pb, Bi, Zn, Sb, Pd, C, Pt, or the like may be used. The pointed heads of the bump electrodes preferably may have a rectangular, circular, or elliptical shape with a size of one side or a diameter of an extremity thereof not greater than about 20 µm. It is particularly preferable for the size of the pointed heads to be not greater than 10 µm.

Another method of producing the circuit substrate may include the steps of: previously forming the conductive adhesive layers 3 on the separate resin film 40 as described above to prepare the resin film 4; covering the circuit substrate with the resin film 40 for the conductive adhesive layers to face the input/output terminal electrodes of the circuit substrate 1; and bonding the resin film to the substrate. In order to form the conductive adhesive layers 3 on the resin film 40, there can be used a method of applying conductive adhesive paste 30 onto the thermoplastic resin film by printing process with a pattern corresponding to an arrangement of the terminal electrodes 2 on the circuit substrate 1.

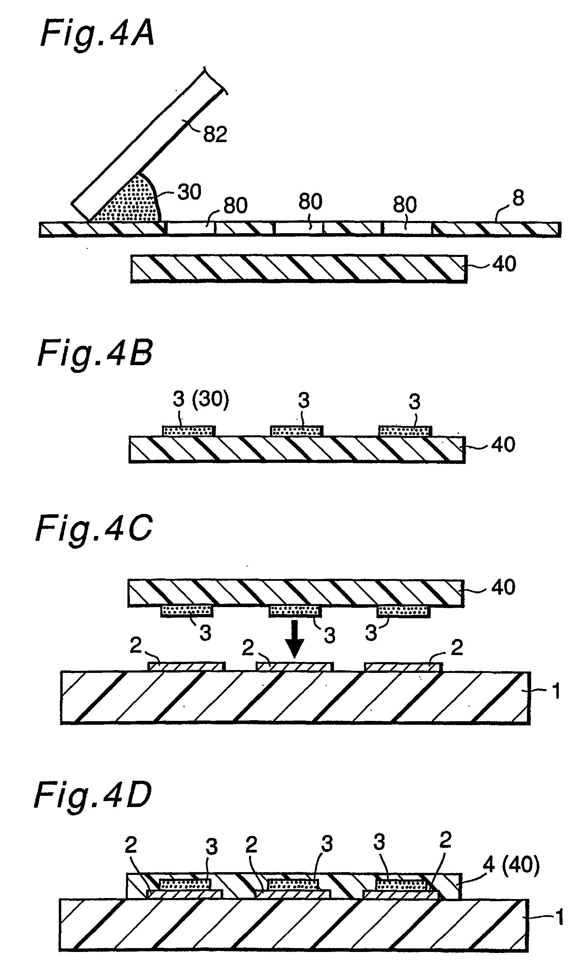

In Fig. 4A, a separate resin film 40 is coated with conductive adhesive paste 30 in a specified thickness, by printing with use of the printing screen mask 8 and the squeegee 82. The conductive adhesive applied may preferably be cured. Patterned conductive adhesive layers 3 are thereby formed on the resin film 40 as shown in Fig. 4B.

As shown in Fig. 4C, the resin film 40 having the conductive adhesive layers thereon is bonded onto the circuit substrate 1 such that the conductive adhesive layers 3 accurately oppose to the respective input/output terminal electrodes 2 on the circuit substrate and cover the terminal electrodes 2. For bonding, the resin film 40 is heated to such an extent that a surface of the resin film is sticking. Thus, this process, as shown in Fig. 4D, can provide the circuit substrate to which the conductive adhesive layers 3 and the resin film 4 are integrated.

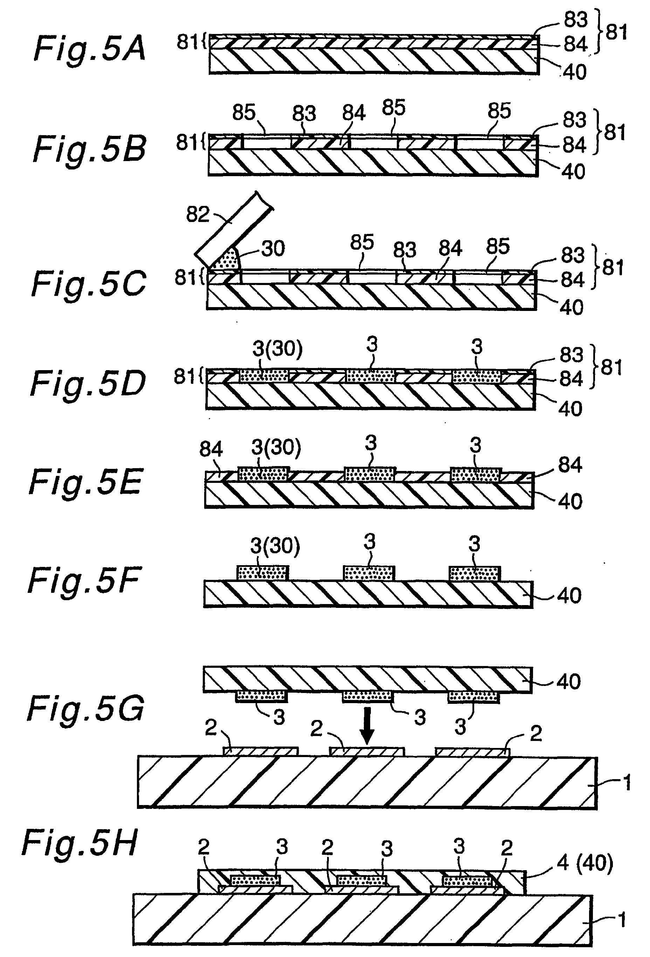

Another method of forming the conductive adhesive layers 3 on the resin film 40, as shown in Figs. 5A to 5F, when preparing the resin film 4, may include: bonding initially a masking sheet 81 onto a resin film 40; and boring through holes 85 with a specified pattern through the bonded masking sheet 81 to form a mask 8.

In this method, the through holes 85 are bored through the masking sheet 81 so as to coincide with positions on the resin film 40 that correspond to the terminal electrodes 2 on the circuit substrate 1. The through holes 85 end at a surface of the substrate that makes bottom surfaces thereof and are filled with conductive adhesive paste 30. After the filling, only the masking sheet 81 is removed. With the removal of the masking sheet 81, the paste 30 that has filled the through holes 85 remains as the conductive adhesive layers 3 with a desired pattern on the circuit substrate. The masking sheet 81 is preferably composed of two layers, i.e., a separate resin sheet 84 to be bonded onto the resin film 40 and a release sheet 83 that adheres onto the sheet 84. The through holes are formed so as to pierce the resin sheet 84 and the release sheet 83. The masking sheet composed of two layers has an advantage in improving formability of conductive adhesive, for the following reason. At the time of filling, the conductive adhesive paste 30 is left also on the release sheet 83 outside the through holes, and there is a fear that conductive adhesive inside the through holes might be exfoliated and removed simultaneously with the removal of the resin sheet 84 if the paste that has overflowed the through holes is cured. If only the release sheet 83 can immediately be stripped off while the paste being in a soft state after filling, however, conductive adhesive can be reliably and fully fed only into the through holes and the cured resin sheet 84 has only to be stripped off afterward.

In the method of producing the circuit substrate 1, which is shown in Figs. 5A to 5H, in detail, the separate resin sheet 84 and the release sheet 83 stacked on the sheet 48 are initially bonded as the masking sheet 81 onto the resin film 40, as shown in Fig. 5A. Because the resin film 40 is to be the resin film 4 when the resin sheet 84 and the release sheet 83 are removed later, those are used which can easily be separated from the resin film 40. For the release sheet 83, Teflon, cellophane, polyethylene terephthalate), silicone, or the like, may be used which is non-adhesive and have releasable property. For the resin sheet 84 may be used, for example, resin soluble in acid or alkali, such as polyacetal, polycarbonate, epoxy resin, phenolic resin and polyester.

In the next step, as shown in Fig. 5B, the through holes 85 through the resin sheet 84 and the release sheet 83 both stacked on the resin film 40 are accurately positioned to the corresponding terminal electrodes 2 provided on the circuit substrate 1. The resin sheet 84 and the release sheet 83 are scanned with a laser beam, and positions therein corresponding to the terminal electrodes 2 are illuminated with the laser beam to be heated and melted so that the through holes 85 are opened and formed.

The through holes can be formed by ultraviolet irradiation instead of the laser irradiation. In ultraviolet irradiation method, resin sensitive to ultraviolet rays is used. As the resin for this purpose, ultraviolet curing epoxy or acrylic resin can be used preferably. When portions to be opened of uncured release sheet 83 are masked for interception of rays of light and the sheet is irradiated with ultraviolet rays in this method, portions of the resin other than the masked portions are cured whereas the portions to be opened directly under the intercepting mask remain uncured. Then removal of the uncured portions results in formation of the through holes.

In the next step, as shown in Figs. 5C and 5D, paste 30 of conductive adhesive is extended on the release sheet 83 with the squeegee 82, so that the through holes are filled with the paste. The embedded paste 30 of conductive adhesive is then cured. If solvent-type resin is used in the conductive adhesive, the adhesive can be cured by vaporization of its solvent. After that, the release sheet 83 is pealed off as shown in Fig. 5E and acid-soluble resin of the resin sheet is removed, as shown in Fig. 5F, by acid treatment with hydrochloric acid, sulfuric acid or the like.

The resin film 40 thus having the patterned conductive adhesive layers 3 is bonded onto a circuit substrate as shown in Fig. 5G. For bonding, a method of heating the resin film 40 to a temperature range is employed in which the resin film is softened so as to adhere to the surface thereof. Thus, as shown in Fig. 5H, the circuit substrate 1 in which the conductive adhesive is integrated with the resin film 4 can be obtained.

In a package structure using the circuit substrate of the invention in which the bump electrodes of a semiconductor device are electrically and mechanically connected to input/output terminal electrodes 2 of the circuit substrate 1 through conductive adhesive, the semiconductor device being bonded by a resin film 4 formed previously on the circuit substrate 1, an elastomer layer, which is elastically softer than the resin film 4 or sealing resin, may be interposed between the semiconductor device and the resin film 4.

In a method of producing the package structure, the semiconductor device 5 has the bump electrodes 7, the circuit substrate has the input/output terminal electrodes 2 on the surface thereof, and a separate resin film 4 is previously provided with conductive adhesive layers 3 corresponding to the terminal electrodes 2 of the circuit substrate 1, on one side of the film, and with an elastomer layer corresponding to the semiconductor device 5, on the other side of the film.

In this embodiment, the circuit substrate 1 has a substrate body on which terminal electrodes 2 as described above are arranged, conductive adhesive layers 3 on the terminal electrodes 2, a resin film 4 covering the layers, a elastomer layer provided on the resin film 4. The elastomer layer on the circuit substrate 1 may be interposed between a semiconductor functional part of the semiconductor device 5 and the resin film 4 on the circuit substrate, then constituting a package structure.

As the elastomer layer, a layer of synthetic resin (including elastic synthetic rubber) may be used which is softer and has a lower elasticity modulus than the resin film 4. In this arrangement, at least the semiconductor functional part of the semiconductor device 5 is protected by the elastomer layer. The elastomer absorbs and reduces a stress that acts through the rigid resin film 4 or an impulsive force from outside, and therefore prevents damage to and degradation in function of the semiconductor functional part, e.g., an integrated circuit portion on a semiconductor substrate 50.

The elastomer layer may preferably be a silicone elastmer layer with respect to the resin film 4 of epoxy.

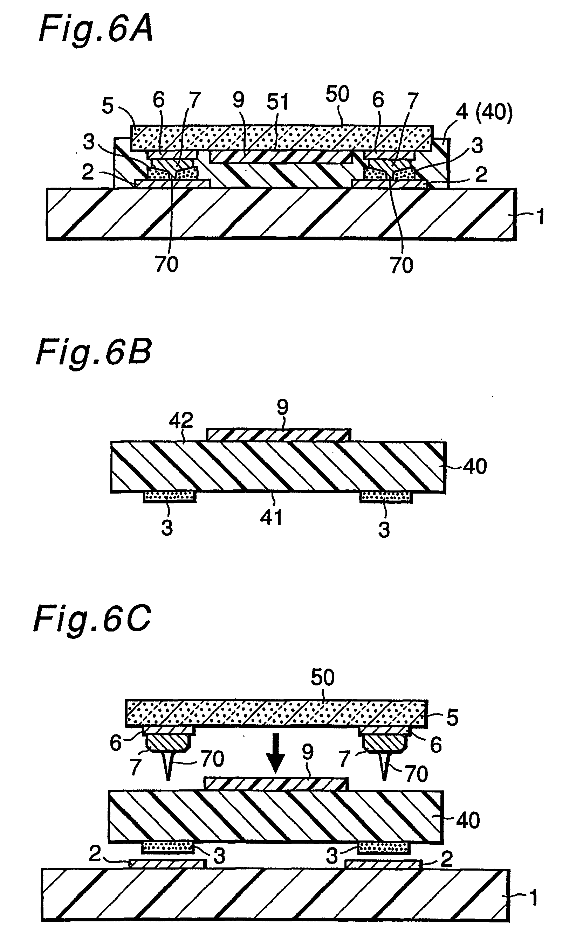

Fig. 6A shows an example of package structure having the elastomer layer 9, in which the bump electrodes 7 formed on the input/output terminal electrodes 6 (pad electrodes) of the semiconductor device 5 are connected and fixed to the terminal electrodes 2 of the circuit substrate 1 through the conductive adhesive; the peripheries of connecting portions between the electrodes 2 and 7 are reinforced by a resin film 4; the elastomer layer 9 of silicone rubber is provided between the resin film of epoxy and the surface of the semiconductor device 5 on which a semiconductor functional part 51 is arranged; and the elastomer layer 9 isolates the resin film which is rigid. This can thus reduce damage to the functional element on the semiconductor device 5. Further, the conductive adhesive can relax stresses developed when packaging and thereby avoid deteriorating characteristics of the elements and breaking interconnections.

Fig. 6B shows a resin film 40 used on the circuit substrate 1 for use in the package structure wherein the resin film has conductive adhesive layers 3 in a specified pattern on one surfaces thereof and has an elastomer layer 9 fixed to the other surface. In this example, the elastomer layer 9 is positioned so as to face the semiconductor functional part 51 of the semiconductor device 5 when it is incorporated into the package structure.

Figs. 6A and 6C show a process of assembling the package structure with use of the resin film 40 to which the elastomer layer 9 is attached, and show the resultant package structure. In assembling, the conductive adhesive layers 3 on the one surface of the resin film are made to correspond to the terminal electrodes 2 of the circuit substrate 1, and the semiconductor device 5 is placed correspondingly on the other surface of the resin film 40 having the elastomer layer 9 so that the elastomer layer 9 is positioned on the semiconductor functional part 51. In a softened state of the resin film 40 during heating, the semiconductor device 5 is pressed toward the circuit substrate 1 so that the bump electrodes 7 on the terminal electrodes (pads) 6 may pierce the resin film 40 and reach the conductive adhesive layers 3, achieving connections. The resin film 40 fills a space between the circuit substrate and the semiconductor device 5, making the elastomer layer 9 pad onto the semiconductor device 5, and bonds integrally the semiconductor device 5 with the circuit substrate 1.

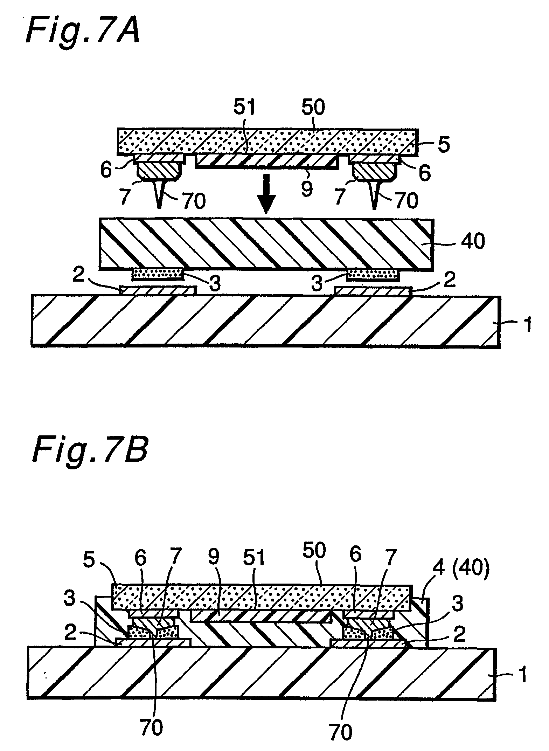

Figs. 7A and 7B show another example of assembly using the elastomer layer 9. In Fig. 7A, the elastomer layer has previously been attached or bonded to the semiconductor device 5. In Fig. 7B, by pressing the semiconductor device 5 toward the circuit substrate 1 in the same manner as shown in Fig. 6C, the bump electrodes 7 of the semiconductor device 5 is pierced into the resin film 40, reaching the conductive adhesive layers 3, and further the resin film 40 presses the elastomer layer 9 to the semiconductor device 5 and integrates the semiconductor device 5 with the circuit substrate 1.

In a package structure of a third embodiment of the invention, a space between a circuit substrate and a semiconductor device may be filled with liquid sealing resin together with the resin film. In a method of producing such a circuit substrate 1, such liquid sealing resin may be used instead of the resin film or with the resin film on which the liquid sealing resin is applied.

Using the liquid sealing resin, a sealing resin may be porous. The existence of air bubbles in the sealing resin provides an advantageous structure in that the semiconductor device does not reduce much in high-frequency property because a dielectric constant of air is apparently lower than that of resin. such a sealing resin may contain foaming components which generate air bubbles when the resin components react to be cured. After curing, the air bubbles generated in the liquid resin remain as pores, the sealing resin being porous. A content of the air bubbles can be changed, for example, by controlling quantities of reactive diluent and the like.

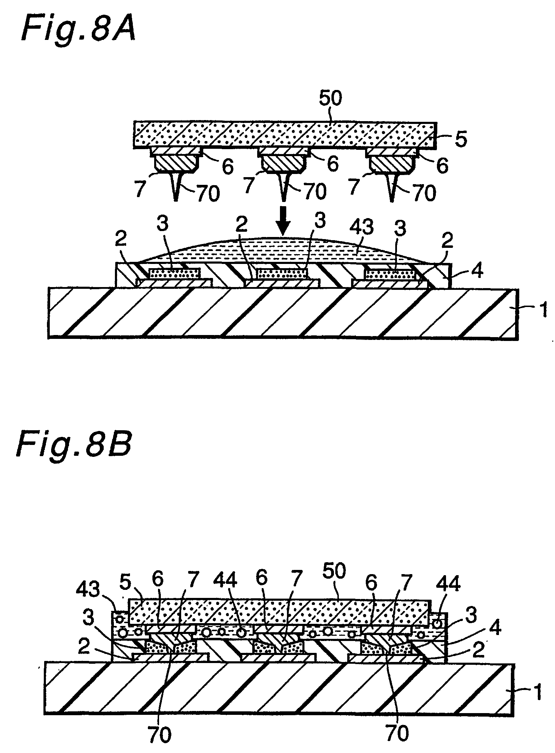

In use of liquid resin, as shown in Fig. 8A, liquid sealing resin is coated or dropped onto the resin film 4 on the circuit substrate; the semiconductor device is pressed toward the circuit substrate; the bump electrodes 7 then is pierced into the resin film 4 to reach the conductive adhesive layers 3 and to make connections to the terminal electrodes 2, becoming contact with the liquid sealing resin residing on the resin film 4; and the liquid sealing resin is filled in a space between the circuit substrate 1 and the semiconductor device 5 to bond both the substrate and the device together after cured. Fig. 8B shows the package structure assembled in such a manner. The package structure shown in Fig. 8B exhibits an example where the liquid sealing resin is foaming resin which contains air bubbles 44 coexisting.

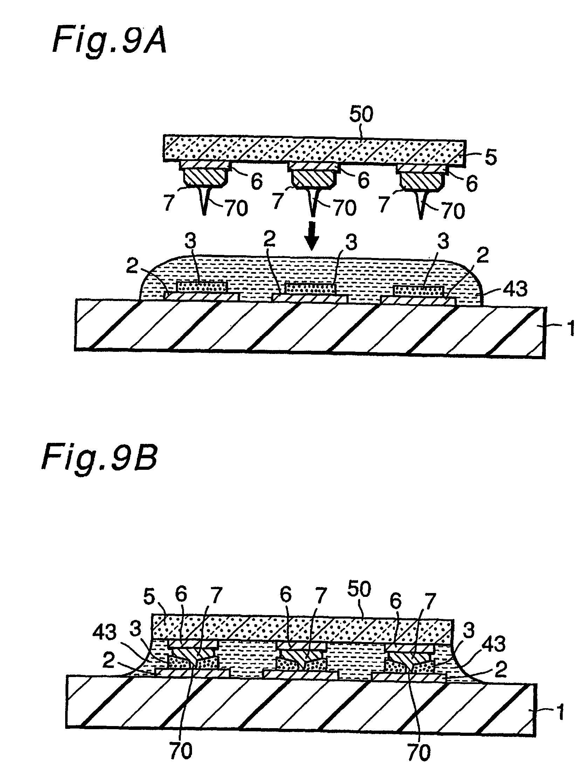

Figs. 9A and 9B show an example in which terminal electrodes 2 on a circuit substrate are covered only with liquid sealing resin, without using resin film. In Figs. 9A and 9B, bump electrodes 7 on terminal electrodes (pads) of a semiconductor device 5 are connected to conductive adhesive on the terminal electrodes 2 of the circuit substrate 1, and the sealing resin is filled in a space between the semiconductor device 5 and the circuit substrate 1 which are sealed.

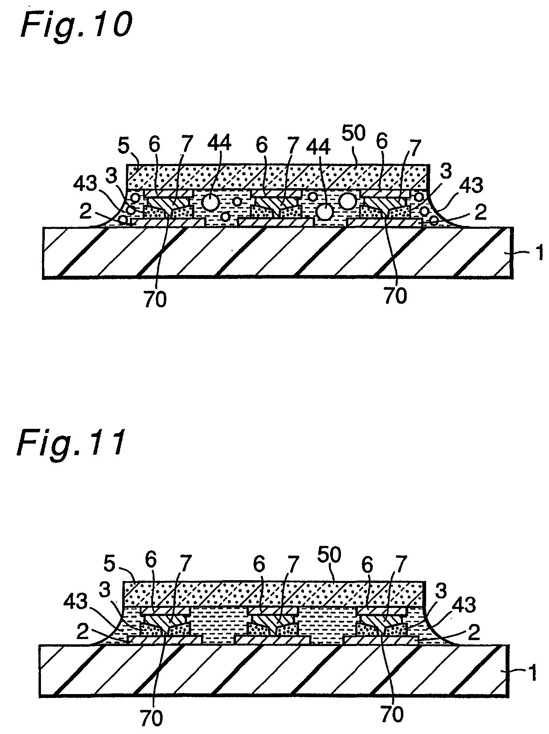

Fig. 10 shows an example where air bubbles 44 are made to remain in sealing resin filling a space between a semiconductor device 5 and a circuit substrate 1 so that the resin is made porous. A package structure having such air bubbles 44 prevents a high-frequency property of the semiconductor device 5 from reducing. The liquid sealing resin contains foaming components to foam when cured.

### Embodiments:

### [Embodiment 1]

Fig. 11 shows a schematic section of a package structure for a semiconductor device 5 used in a test that will be described below, i.e., the structure in which bump electrodes of the semiconductor device 5 are mounted on input/output terminal electrodes of a circuit substrate with junction layers between and which is reinforced with sealing resin.

In embodiment 1, Au bumps formed as the bump electrodes by wire bonding method were mounted on the terminal electrodes of the circuit substrate through conductive adhesive as the junction layers, and sealed with epoxy sealing resin was executed.

In conventional example 1, Ni-Au electroless plated bumps were used as the bump electrodes, and solder as the junction layers and ultraviolet curing epoxy resin as the sealing resin were used.

In each of the embodiment and the conventional example, a package structure for n-channel MOS transistor was produced and deterioration of the transistor was examined by a change in threshold voltage.

In results of the test, the n-channel MOS transistor of the embodiment exhibited a change in threshold voltage not greater than 0.7% with respect to a mounting load of 1 g per bump.

In the conventional soldering method, by contrast, a threshold voltage of the n-channel MOS transistor changed by approximately 10% in comparison with that in an initial stage, after the mounting with a mounting load of 10 g per bump.

Other package structures for SRAM according to the embodiment of the invention were produced in the same manner under mounting loads of 1 g and 20 g per bump, and achieved in good connections after the mounting, with no bit error (0/228) occurring due to the mounting operation.

In consideration of these results, it is found that, in the soldering method of the conventional example, the junction layers has no component capable of relaxing a shrinkage stress which acts when the sealing resin is cured so that the stress acts directly on the semiconductor device and changes its threshold voltages. On the contrast, in the embodiment, soft conductive adhesive as junction layers can relax a curing shrinkage stress caused by the sealing resin, and therefore no stress acts on a semiconductor substrate of the semiconductor device, so that the satisfactory result can be obtained. A result of stress analysis also indicates that the package structure using the conductive adhesive layers 3 can hardly produce stress therein. Therefore, it should be understood that conductive resin adhesive is an effective component for the stress relaxation.,

As an conventional example, tests of packaging a semiconductor device were conducted using a conventional anisotropic conductive film 49 shown schematically in Fig. 16A. Herein, bump electrodes of the semiconductor device were Au bumps formed with use of wire bonding method, and there were used two types of circuit substrates, i.e., a ceramic substrate and a glass-epoxy substrate (a glass-fiber-reinforced epoxy substrate, hereinafter the same) (FR4) and the anisotropic conductive film having a thickness of 70 µm and containing Ni filler with a diameter of 5 µm. The packaging tests were conducted in which a mounting load between the bump electrodes of the semiconductor device and the circuit substrate was varied within a range from 10 to 80 g per bump electrode.

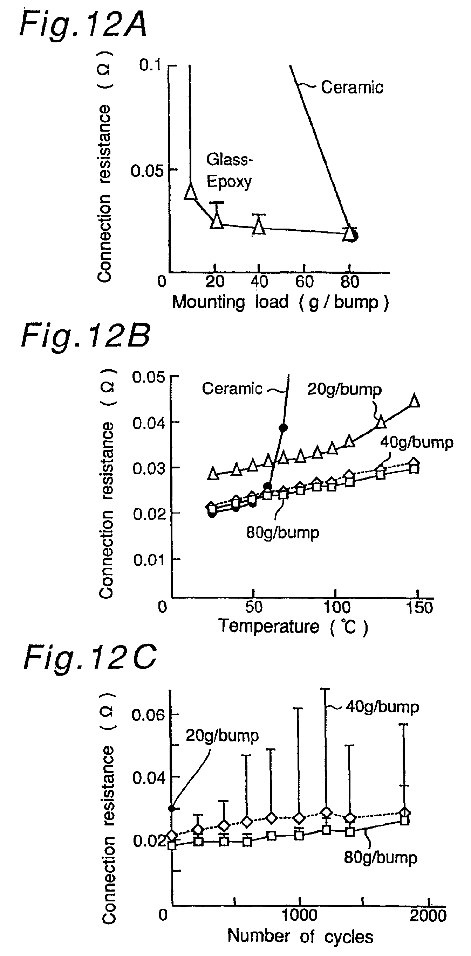

Fig. 12A shows relations between initial connection resistances per bump after the mounting and the bump loads. The connection resistance includes electric resistances of the terminal electrode and the Au bump of the semiconductor device, and an electric resistance of the anisotropic conductive film. As for the ceramic substrate, initial connection was not obtained unless a mounting load not less than 80 g per bump was achieved. As for the glass epoxy substrate, the resistance was found to be unstable unless an initial load not less than 40 g per bump was applied.

Fig. 12B shows a change in resistance with respect to temperature in each sample, and the resistance change for the glass epoxy substrate (FR4) was found to be stable with mounting loads not less than 40 g per bump. Results of a heat shock test (a heat cycle in liquid phase is from -55 to 125°C) shown in Fig. 12C, however, were unstable with a mounting load of 40 g per bump and stable with 80 g per bump.

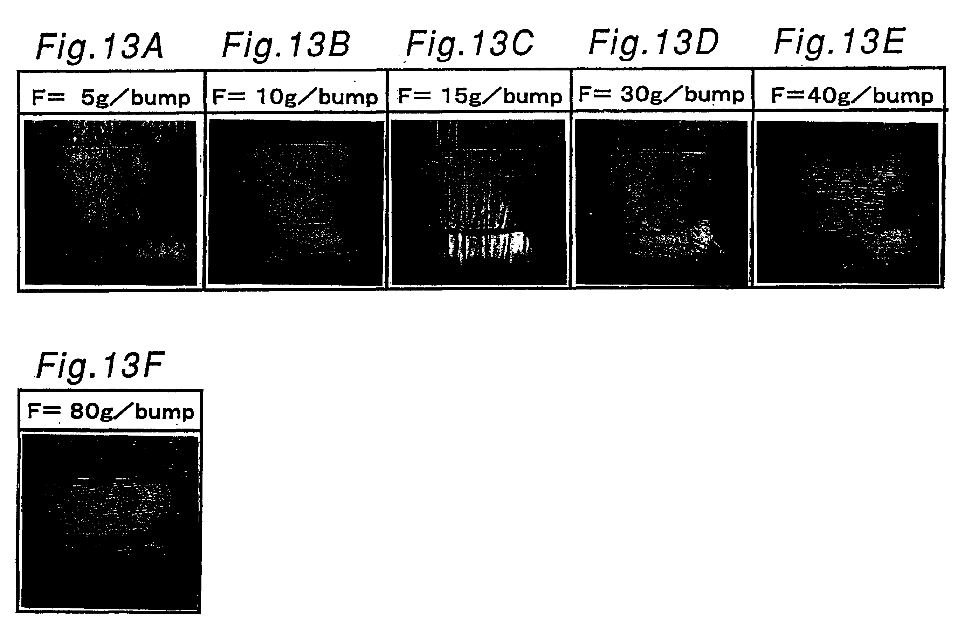

Figs. 13A to 13E are a series of photomicrographs obtained by microscopic observation in the vicinity of an electrode in a cross section of a package structure in which loads for bonding varied from 5 to 40 g per bump using a glass-epoxy substrate (FR4) as a circuit substrate and. In each of these photographs, a pad electrode fixed to the circuit substrate is shown on the lower side and a bump electrode on the side of a semiconductor chip is shown on the upper side. These photographs indicate that deformation of the bump electrode was caused with mounting loads on the order of 15 g per bump or larger.

Fig. 13F shows a photomicrograph of a cross section in the case of using a ceramic substrate. This substrate having rigidity, input/output terminal electrodes were not deformed even with a mounting load of 80 g per bump, but unstable initial connection might develop faulty connection under the temperature characteristic of Fig. 12B.

### Embodiment 2

Packaging tests were conducted with use of a circuit substrate of the invention. A glass-epoxy substrate (FR4) was used as the circuit substrate and the package structure shown in Figs. 2A and 2B was tested. An epoxy resin film having a thickness of 50 µm was attached onto a surface of the circuit substrate including top surfaces of input/output terminal electrodes.

As bump electrodes of a semiconductor device, Au bumps with a size of the pointed head of 20 µm square were formed according to wire bonding method. In the mounting structure, the semiconductor device 5 had the bump electrodes on the chip pressed on and connected to the input/output terminal electrodes of the circuit substrate having the resin film previously bonded thereto, and the structure was reinforced by sealing resin filled in a space between the resin film and the chip. The tests were conducted with a variation of loads for pressing the bumps of the semiconductor device to the electrodes on the circuit substrate.

The package structure obtained was tested on initial connection performance with respect to the mounting loads per bump and on connection performance after reflowing and, in addition, tests were made of heating the structure repeatedly five times at 270°C.

Table 1 shows the test results. Samples having this package structure exhibited stable and good electrical and mechanical connection performance over all the connections between the bump electrodes and the pad electrodes, with pressure with loads not lower than 20 g per bump at the time of the mounting.

**Table 1**

| | | | | |
|---|---|---|---|---|
| Mounting load (g/bump) | 5 | 10 | 20 | 40 |
| Connectability after mounting | Good | Good | Good | Good |
| Connectability after reflow (240°C) | Failure | Good | Good | Good |
| Solder heat test(five times at 270°C) | Failure | Failure | Good | Good |

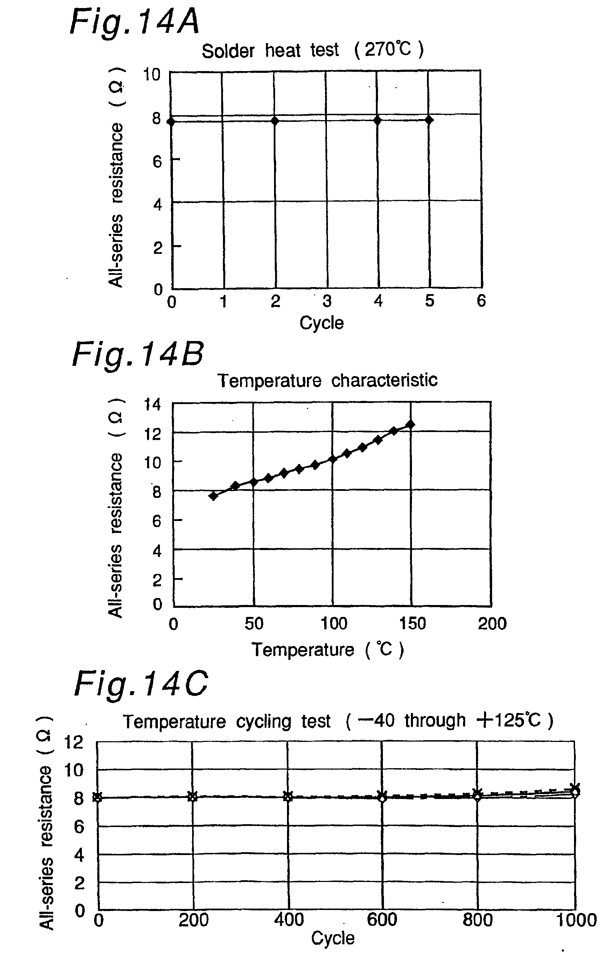

Fig. 14A shows a change in the resistance of the junction portions in each stage of the solder heat tests. In the solder heat tests, samples with mounting loads not lower than 20 g per bump show no change in junction resistance, even when heating is repeated 5 cycles at 270°C.

Fig. 14B shoes stable connection performance in temperature characteristics of the junction resistance, and it was found that a satisfactory result was obtained.

Fig. 14C shows a result of a repetition test between heating (+125°C) and cooling (-40°C) (temperature cycling test) run on eight samples having the obtained package structure (united with a mounting load of 20 g per bump). There is little change in all series connection resistance of all the junction portions even after 1000 cycles, and there is no substantial difference in the resistance change among the eight samples.

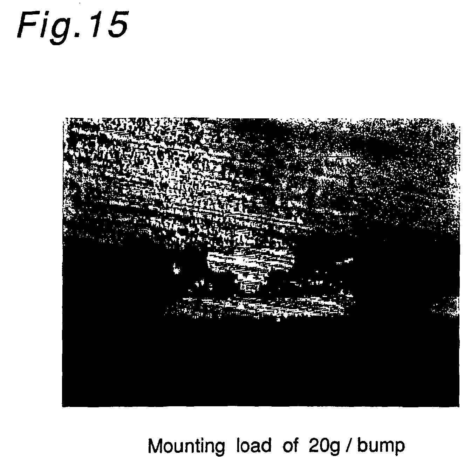

Fig. 15 is a photograph showing a cross section of a junction portion including a bump electrode and a pad electrode in a package structure of the embodiment produced with a mounting load of 20 g per bump, and shows that the input/output terminal electrodes of a substrate thereof are not deformed under the load, which makes packaging with a low stress possible. It is found from the above test results that stable connection can be obtained with lower loads than in the packaging method of using the conventional anisotropic conductive film.

### INDUSTRIAL APPLICABILITY

The circuit substrate of the invention and the method of producing the same can be utilized for producing and using substrates which are provided for the electrical industry, particularly for the semiconductor manufacturing industry. The invention of the method of producing the package structure of a semiconductor device can be widely used for production and use of semiconductor package structures in the electrical industry, particularly in the semiconductor manufacturing industry.

## Claims

1. A circuit substrate for packaging a semiconductor device, the circuit substrate comprising:
input/output terminal electrodes formed on a surface of a main body of the substrate;
conductive adhesive layers adhering onto the terminal electrodes; and
a resin film formed on the surface of the substrate so as to cover the conductive adhesive layers together with the terminal electrodes.

2. A circuit substrate to be mounted with a semiconductor device, wherein the circuit substrate comprises:
a main body of the circuit substrate having input/output terminal electrodes arranged on a surface thereof;
a resin film provided with conductive adhesive layers and an elastomer layer thereon wherein the elastomer layer is previously placed on a surface opposite to a surface on which the conductive adhesive layers are formed and in a position corresponding to at least a part of a surface of the semiconductor device on which a functional part of the semiconductor device resides, and the conductive adhesive layers are placed in positions on the surface of the resin film corresponding to the terminal electrodes on the surface of the main body of the circuit substrate.

3. A method of producing a circuit substrate to be mounted with a semiconductor device, the method comprising:
applying conductive adhesive by printing onto input/output terminal electrodes formed on a surface of a main body of the substrate and thereby forming conductive adhesive layers; and
after curing the conductive adhesive layers, coating the surface of the substrate with a resin film so as to cover the conductive adhesive layers and the terminal electrodes.

4. A method of producing a circuit substrate for packaging a semiconductor device, the method comprising:
forming previously conductive adhesive layers on a separate resin film to prepare the resin film;
covering the circuit substrate with the resin film so that the conductive adhesive layers face input/output terminal electrodes of the circuit substrate; and
bonding the resin film to the circuit substrate.

5. The method of producing a circuit substrate according to Claim 4, wherein conductive adhesive paste is previously applied onto the resin film by printing process with a pattern so as to form the conductive adhesive layers and the resin film is thereby prepared.

6. The method of producing a circuit substrate according to Claim 4, wherein the preparation of the resin film comprises bonding a masking sheet onto the resin film, thereafter boring through holes that extend through the masking sheet, filling the through holes with conductive adhesive, and thereafter removing the masking sheet.

7. The method of producing a circuit substrate according to Claim 6, wherein the masking sheet comprises a resin sheet that is to be bonded onto the resin film and a release sheet that is releasably stuck on the resin sheet.

8. The method of producing a circuit substrate according to Claim 4, wherein the method for boring comprises perforating the through holes through the masking sheet by laser illumination.

9. The method of producing a circuit substrate according to claim 4, wherein the method of boring comprises perforating the through holes through the masking sheet by ultraviolet illumination.

10. A package structure having a semiconductor device mounted on a circuit substrate, in which:
bump electrodes of the semiconductor device are electrically and mechanically connected to conductive adhesive placed on input/output terminal electrodes provided on the circuit substrate,
the semiconductor device and the circuit substrate are bonded and fixed to each other through medium of a resin film or sealing resin in a space between the semiconductor device and the circuit substrate, and
an elastomer layer that is softer and more elastic than the resin film or the sealing resin is interposed between a functional part of the semiconductor device and the resin film or the sealing resin.

11. A method of producing a package structure having a semiconductor device mounted on a circuit substrate, wherein: the semiconductor device has bump electrodes, the circuit substrate has input/output terminal electrodes on a surface of the substrate, the method comprising:
applying conductive adhesive layers onto the terminal electrodes of the substrate;
covering a resin film on the surface of the substrate including the conductive adhesive layers;
pressing the bump electrodes of the semiconductor device into the resin film melted on the circuit substrate by heating to penetrate through and fixed to the conductive adhesive layers, then the bump electrodes being electrically connected to the corresponding terminal electrodes of the substrate; and
subsequently curing the resin film to join the semiconductor device to the circuit substrate.

12. The method of producing a package structure according to claim 11, wherein liquid sealing resin is used instead of the resin film or with together the resin film on which the liquid sealing resin is applied.

13. A method of producing a package structure having a semiconductor device mounted on a circuit substrate, wherein:
the semiconductor device has bump electrodes, the circuit substrate has input/output terminal electrodes on a surface of the substrate, a separate resin film has conductive adhesive layers corresponding to the terminal electrodes of the circuit substrate, on one surface of the film, and has an elastomer layer corresponding to the semiconductor device, on the other surface of the film, the method comprises:
positioning the resin film correctly on the circuit substrate;
pressing the bump electrodes of the semiconductor device into the resin film melted on the heated circuit substrate to reach the conductive adhesive layers, and are connected to the corresponding terminal electrodes of the substrate,
curing and the resin film to join the semiconductor device to the circuit substrate.

14. A method of producing a package structure, according to claim 11, wherein the semiconductor device has bump electrodes and an elastomer layer bonded onto a part of a surface corresponding a semiconductor functional part of the semiconductor device, and the package structure has the elastomer layer interposed between the resin layer and the semiconductor device.
